Europäisches Patentamt

European Patent Office

Office européen des brevets

(11) Veröffentlichungsnummer: **0 565 818 A2**

# (12) EUROPÄISCHE PATENTANMELDUNG

(21) Anmeldenummer: **93101608.3**

(22) Anmeldetag: **03.02.93**

(51) Int. Cl.5: **G03F 7/11**, G03F 7/027, B41N 1/12

(30) Priorität: **07.02.92 DE 4203608**

(43) Veröffentlichungstag der Anmeldung: **20.10.93 Patentblatt 93/42**

(84) Benannte Vertragsstaaten: **DE FR GB**

(71) Anmelder: **BASF Lacke + Farben AG Glasuritstrasse 1 D-48165 Münster-Hiltrup(DE)**

(72) Erfinder: **Telser, Thomas, Dr. Langer Wiesenweg 13 W-6940 Weinheim(DE)** Erfinder: **Werther, Heinz-Ulrich, Dr. Hans-Hoffmann-Strasse 12 W-6706 Wachenheim(DE)** Erfinder: **Zuerger, Manfred Holderlandstrasse 2 W-6920 Sinsheim(DE)**

(74) Vertreter: **Karau, Wolfgang, Dr. et al BASF Aktiengesellschaft, Patentabteilung ZDX - C 6 D-67056 Ludwigshafen (DE)**

(54) **Verfahren zur photochemischen oder mechanischen Herstellung flexibler Drucktormen.**

(57) Die Erfindung betrifft ein Verfahren zur Herstellung von flexiblen Druckformen aus Druckplatten, im wesentlichen bestehend aus einem formstabilen Träger (1) und einer Aufzeichnungsschicht (2), wobei die Herstellung der Druckform wahlweise entweder durch photochemische oder durch mechanische Strukturierung erfolgt, und im Falle der photochemischen Strukturierung die lichtempfindliche Aufzeichnungsschicht (2) bildmäßig belichtet und die nicht belichteten Teile der Aufzeichnungsschicht (2) mit einem Entwickler ausgewaschen werden, im Falle der mechanischen Strukturierung die ursprünglich lichtempfindliche, vollflächig belichtete Aufzeichnungsschicht (2) bildmäßig geschnitten und die nichtdruckenden Teile der Aufzeichnungsschicht (2) vom Träger (1) abgezogen werden.

Die nach diesem Verfahren hergestellten Druckformen eignen sich zur Herstellung von Flexodruckerzeugnissen und zur Lackierung von Offsetdruckerzeugnissen.

EP 0 565 818 A2

Die Erfindung betrifft ein Verfahren zur Herstellung von flexiblen Druckformen aus Druckplatten, im wesentlichen bestehend aus einem formstabilen Träger und einer Aufzeichnungsschicht, wobei die Herstellung der Druckformen wahlweise entweder durch photochemische oder durch mechanische Strukturierung erfolgt. Die so hergestellten flexiblen Druckformen eignen sich sowohl zur Herstellung von Flexodruckerzeugnissen als auch zur Lackierung von Offsetdruckerzeugnissen.

Als Druckformen für die Offsetlackierung werden unterschiedliche Systeme eingesetzt.

Bei der vollflächigen Lackierung werden Gummitücher verwendet. Nachteilig ist hier das Aufbauen der noch feuchten Offsetfarbe auf dem Gummituch. Der Druckvorgang muß unterbrochen, und das Gummituch gereinigt werden.

Sollen beim Lackauftrag nur wenige Stellen ausgespart werden, so schneidet man aus dem Gummituch die Stellen heraus und zieht sie manuell ab. Nachteile dieses Systems sind eine ungenügende Maßhaltigkeit des strukturierten Gummituches, was einem passergenauen Lackauftrag bei hohen Auflagen im Wege steht, das Verziehen des Gummituchs beim Abziehen der obersten Schicht, die geringe Auflösung und das Aufbauen der Offsetfarbe. Zur Spotlackierung werden meist photopolymere Flexodruckplatten eingesetzt. Nachteilig sind hier der hohe Aufwand der Klischeeherstellung (Filmherstellen, Belichten, Auswaschen in organischen Entwicklern, Trocknen, Nachbehandeln) und der Farbaufbau.

Aufgabe der vorliegenden Erfindung ist es, das Verfahren zur Herstellung von flexiblen Druckformen für den Flexodruck und insbesondere für deren Anwendung als Offsetlackierplatte einfacher und variabler zu gestalten.

Diese Aufgabe läßt sich erfindungsgemäß im wesentlichen durch eine Druckplatte lösen, die je nach geforderter Auflösung mechanisch strukturiert oder bildmäßig belichtet, ausgewaschen und getrocknet werden kann. Mechanisches Strukturieren heißt in diesem Zusammenhang, daß aus der Druckplatte die nicht druckenden Bereiche bildmäßig, z.B. mittels eines Rechner gesteuerten Messers oder manuell herausgeschnitten und abgezogen werden.

Gegenstand der vorliegenden Erfindung ist ein Verfahren zur Herstellung von flexiblen Druckformen aus Druckplatten, im wesentlichen bestehend aus einem formstabilen Träger (1) und einer Aufzeichnungsschicht (2), das dadurch gekennzeichnet ist, daß die Herstellung der Druckform wahlweise entweder durch photochemische oder durch mechanische Strukturierung erfolgt, wobei im Falle der photochemischen Strukturierung die lichtempfindliche Aufzeichnungsschicht (2) bildmäßig belichtet und die nicht belichteten Teile der Aufzeichnungsschicht (2) mit einem Entwickler ausgewaschen werden, im Falle der mechanischen Strukturierung die ursprünglich lichtempfindliche, vollflächig belichtete Aufzeichnungsschicht (2) bildmäßig geschnitten und die nichtdruckenden Teile der Aufzeichnungsschicht (2) vom Träger (1) abgezogen werden.

Auf der Aufzeichnungsschicht (2) kann sich eine Schutzfolie (3) befinden.

Zwischen der lichtempfindlichen Aufzeichnungsschicht (2) und der Schutzfolie (3) kann sich eine dünne Entklebungsschicht (2a) befinden, die im Falle der photochemischen Strukturierung nach der bildmäßigen Belichtung entfernt wird, im Falle der mechanischen Strukturierung vor oder nach dem bildmäßigen Schneiden abgezogen oder abgewaschen wird.

Zwischen der Aufzeichnungsschicht (2) und dem formstabilen Träger (1) kann zusätzlich eine Haftschicht (1a) angeordnet sein.

Als formstabiler Träger (1) wird vorzugsweise eine maßhaltige Kunststoffolie eingesetzt.

Eine bevorzugte Ausgestaltung des erfindungsgemäßen Verfahrens besteht auch darin, daß die Haftung der Aufzeichnungsschicht (2) zum formstabilen Träger (1) oder zu einer auf dem formstabilen Träger (1) befindlichen Haftschicht (1a) über 1 N/cm und unter 10 N/cm liegt.

Im Falle der mechanischen Strukturierung ist bevorzugt, daß die Reißkraft der Aufzeichnungsschicht (2) über 0,2 N/mm$^2$ und unter 20 N/mm$^2$ liegt.

Bevorzugte Ausführungsformen des erfindungsgemäßen Verfahrens bestehen auch darin, daß die Härte der belichteten Aufzeichnungsschicht (2) über 20 und unter 80 Shore A liegt und im Falle der photochemischen Strukturierung als Entwickler Wasser oder wäßrige Lösungen verwendet werden.

Die lichtempfindliche Aufzeichnungsschicht (2) enthält vorzugsweise ein Gemisch aus einem hydrophoben und einem hydrophilen Bindemittel in solchen Anteilen, daß die belichtete und mit Entwickler ausgewaschene Aufzeichnungsschicht (2) nach 24 Stunden Lagerung in Wasser bei Raumtemperatur eine Gewichtszunahme von > 1 Gew.-% und < 30 Gew.-% aufweist.

Gegenstand der vorliegenden Erfindung ist auch ein Verfahren zur Herstellung von Flexodruckerzeugnissen, wobei als Druckformen solche eingesetzt werden, die nach einem erfindungsgemäßen Verfahren hergestellt werden, sowie ein Verfahren zur Lackierung von Offsetdruckerzeugnissen, wobei die Lackübertragung durch die nach einem erfindungsgemäßen Verfahren hergestellten Druckformen erfolgt.

Zum erfindungsgemäßen Verfahren ist im einzelnen folgendes auszuführen.

Die für das erfindunggemäße Verfahren einzusetzende Druckplatte besteht im wesentlichen aus einem formstabilen Träger (1), beispielsweise einer dimensionsstabilen Trägerfolie einer Dicke von 100 bis 300 µm, auf die vorzugsweise eine dünne Haftschicht einer Dicke von 0,1 bis 10 µm (1a) aufgebracht wurde, und der darauf angebrachten eigentlichen Aufzeichnungsschicht (2), die zwischen etwa 200 und 8000 µm dick sein kann. Auf letzterer kann eine sogenannte Entklebungsschicht (2a), die etwa 1 bis 5 µm dick sein kann, angebracht sein, die für eine gute Haftung zum Negativ bei der Belichtung von Vorteil ist. Darauf kann eine Schutz- oder Deckfolie (3) einer Dicke von etwa 10 bis 200 µm vorhanden sein, um die Druckplatte vor Beschädigungen zu schützen.

Die Aufzeichnungsschicht (2) ist lichtempfindlich, d.h. sie kann durch bildmäßige Belichtung vernetzt werden. Soll die Druckplatte mechanisch strukturiert werden, so wird die Aufzeichnungsschicht vor dem Schneiden vollflächig vernetzt und die Entklebungsschicht, sofern vorhanden, durch Waschen entfernt.

Die Aufzeichnungsschicht (2) kann prinzipell alle für Flexodruckplatten bekannten Formulierungen enthalten. Üblicherweise besteht eine derartige Rezeptur aus einem oder mehreren elastomeren Bindemitteln, einer oder mehreren ethylenisch ungesättigten Verbindungen, Photoinitiator, Stabilisator und gegebenenfalls weiteren Hilfsstoffen.

Werden als Bindemittel die üblichen Blockcopolymere aus Styrol und Butadien oder Isopren verwendet, zeigen die Druckformen bei ihrer Anwendung als Offsetlackplatte das Phänomen des Farbaufbaus, d.h. die noch feuchte Offsetdruckfarbe setzt sich auf der Druckform fest und baut sich dort auf.

Diesen Nachteil zeigen lichtempfindliche Gemische, wie sie in der EP-A-0 386 514 beschrieben sind, nicht.

Das Aufbauen der Offsetfarbe ist eng mit der Quellung der Druckform im Wasserlack gekoppelt. Ist die Quellung der belichteten Druckform im Wasserlack zu gering (< 1 Gew.-% nach 24 Stunden Lagerung), dann setzt sich die Offsetfarbe schon nach wenigen Druckbogen auf der Oberfläche der Druckform (= Lackplatte) fest. Ist die Quellung zu hoch (> 30 Gew.-%), dann kommt es während der Auflage zu nicht akzeptablen Größenveränderungen und Ablösungen einzelner Reliefelemente.

Die in der EP-A-0 386 514 genannten Formulierungen haben hier den Vorteil, daß sie ein hydrophiles und ein hydrophobes Bindemittel enthalten. Die Quellung der Aufzeichnungsschicht im Wasserlack kann daher durch die Anteile der Bindemittelkomponenten exakt eingestellt werden. Optimal geeignet sind Gemische, die das hydrophile und das hydrophobe Bindemittel in etwa gleichen Teilen enthalten. Diese Formulierungen zeigen keinerlei Farbaufbau und sind auflagenstabil. Die Quellung in verschiedenen Wasserlacken liegt zwischen 3 und 15 Gew.-%.

Diese Formulierungen haben zusätzlich den Vorteil, daß sie in Wasser oder wäßrigen Lösungen entwickelt werden können.

Sollen die Druckformen nur mechanisch strukturiert werden, so braucht die Aufzeichnungsschicht natürlich nicht lichtempfindlich sein und muß dann auch nicht vor dem Schneiden vollflächig belichtet werden. Auf den Zusatz von ethylenisch ungesättigten Verbindungen und Photoinitiator kann dann verzichtet werden. Aber auch für die rein mechanische Strukturierung erwiesen sich die in der EP-A-386 514 genannten Kombinationen aus einem hydrophilen und einem hydrophoben Bindemittel als besonders gut geeignet. Diese Bindemittelkombinationen liefern bei der mechanischen Strukturierung Druckformen geeigneter Härte und hoher Auflösung.

Als Entklebungsschicht (2a) gut geeignet sind wasserlösliche teilweise oder vollständig verseifte Polyvinylalkohole und Polyvinylalkohol/Ethylenoxid-Pfropfcopolymere (vgl. z.B. Mowiol®04/86 der Fa. Hoechst AG).

Die Trägerfolie (1) hat vorzugsweise eine Dicke zwischen 150 und 300 µm. Die Trägerfolie verleiht der Druckplatte die notwendige Maßhaltigkeit und sollte sich beim Abziehen der Nichtbildstellen nicht verformen. Eine 300 µm dicke Polyethylenterephthalatfolie erwies sich als besonders gut geeignet. Um eine gute Anbindung der Trägerfolie an die Haftschicht zu erreichen, ist es zweckmäßig, die Folie mit einem Primer vorzubehandeln. Vorbehandelte Polyethylenterephthalatfolien sind im Markt erhältlich (beispielsweise von den Firmen Kalle, Toray, Rhone-Poulenc).

Wie bereits oben erwähnt, befindet sich zwischen Trägerfolie und Aufzeichnungsschicht vorzugsweise eine Haftschicht (Dicke 0,1 bis 5 µm), mit der eine definierte Haftung eingestellt werden kann. Die Haftung der Haftschicht zur belichteten Aufzeichnungsschicht kann für die Qualität des bildmäßigen Schneidens von entscheidender Bedeutung sein.

Ist die Haftung zur belichteten Aufzeichnungsschicht zu hoch, so können die Nichtbildstellen nach dem Schneiden nur sehr schwer oder überhaupt nicht von der Trägerfolie abgezogen werden. Ist die Haftung dagegen zu gering, so kommt es während des Druckvorganges zu Ablösungen einzelner Reliefelemente. Die Haftung sollte deshalb über 2 und unter 20 N/2 cm liegen. Die optimale Haftung liegt zwischen 5 und 10 N/2 cm.

EP 0 565 818 A2

Die Haftung der belichteten Aufzeichnungsschicht zur Trägerfolie sollte zweckmäßigerweise auch mit der Reißkraft der belichteten Aufzeichnungsschicht abgestimmt sein.

Geht man davon aus, daß beim Abziehen der Nichtbildstellen ein ca. 5 cm breiter Streifen abgezogen werden soll, dann sollte das Material bei einer Haftung von 5 N/2 cm Kräfte von 12,5 N aufnehmen können, ohne zu reißen. Die Reißkraft einer 1 mm dicken Aufzeichnungsschicht sollte dann größer als 0,25 $N/mm^2$ sein.

Für die Qualität des Schneidergebnisses ist ferner die Weiterreißfestigkeit des belichteten Materials und die Gleichmäßigkeit des Reißens von Bedeutung. Die Gleichmäßigkeit des Reißens kann durch Bestimmung der Weiterreißfestigkeit nach DIN 53 507 ermittelt werden. Dabei wird ein eingeritzter Probekörper in eine Zug-Dehnungsapparatur eingespannt und der Kraftverlauf als Funktion des Weges aufgenommen. Ist die zum Reißen der Probe notwendige Kraft innerhalb von +/- 2 % konstant, so pflanzt sich der Riß mit einer konstanten Geschwindigkeit gleichmäßig im Material fort und man erhält beim bildmäßigen Schneiden der belichteten Druckplatte glatte und einwandfreie Kanten.

Zeigt das Kraft/Weg-Diagramm der belichteten Aufzeichnungsschicht dagegen ausgeprägte Kraftspitzen, d.h. die Kraft schwankt stufenweise um mehr als +/- 2 %, dann pflanzt sich der Riß im Material ungleichmäßig fort. Die Kanten der Bildelemente sind dann ungleichmäßig eingeritzt, so daß die Informationsübertragung nicht exakt genug ist.

Von Bedeutung ist ferner die Härte der belichteten Aufzeichnungsschicht. Ein gleichmäßiger Lackauftrag ohne Quetschränder wird besonders mit solchen Schichten erreicht, deren Shore A Härte zwischen 30 und 70 Einheiten liegt (gemessen an 6 mm dicken Proben).

Erfüllt die Druckplatte alle oben genannten Anforderungen bezüglich der mechanischen Eigenschaften, dann kann bei der manuellen Strukturierung eine Auflösung bis zu 1 mm erreicht werden. Dies bedeutet, daß freistehende Punkte und Linien und auch Negativelemente in einer Größe > 1 mm einwandfrei erzeugt werden können. Die Auflösung eines zugeschnittenen Gummituches liegt dagegen nur bei ca. 1 cm.

Der Schneidprozeß kann entweder manuell oder in einer Rechner gesteuerten Schneidapparatur durchgeführt werden. Das manuelle Schneiden birgt die Gefahr, daß die Trägerfolie eingeritzt wird und ihre Stabilität verliert. In einer automatischen Schneidvorrichtung kann dagegen die Absenkung des Messers sehr exakt eingestellt werden (+/- 20 $\mu$m), so daß die Trägerfolie nicht beschädigt wird. Zudem kann die Schneidgeschwindigkeit auf das Material abgestimmt werden, was zu einer weiteren Verbesserung des Schneidergebnisses führt. Automatisch arbeitende Schneidvorrichtungen sind im Handel erhältlich (z.B. Marbaplot® der Firma Marbach etc.).

Das Abheben der ausgeschnittenen Elemente kann von Hand erfolgen. Sind die zu entfernenden Flächen zu groß, ist es sinnvoll, beim Schneiden zusätzliche Hilfsschnitte anzubringen. Besonders einfach lassen sich Streifen einer Breite von bis zu 5 cm abziehen.

Die Erfindung wird an Hand der folgenden Beispiele näher erläutert. Die in den Beispielen genannten Teile und Prozente sind soweit nicht anders angegeben, Gewichtsteile bzw. Gewichtsprozente.

Beispiel 1

Eine lichtempfindliche Mischung wurde auf einem Zweischneckenextruder (z.B. ZSK 53 der Fa. Werner und Pfleiderer) verarbeitet. Die Formulierung für die lichtempfindliche Aufzeichnungsschicht (2) enthielt die folgenden Bestandteile:

40 Teile Ethylen-Acrylsäure-Acrylat-Copolymer aus 60 Gew.-% Ethylen, 20 Gew.-% Acrylsäure, 20 Gew.-% 2-Ethylhexylacrylat (Melt-Flow-Index MFI (160°C, 325 g) = 15)

40 Teile Ethylen-Propylen-Dienkautschuk (z.B. Buna AP 251 der Fa. Hüls, mit 50 Gew.-% Ethylen und 14 Doppelbindungen pro 1000 C-Atomen) (Mooney Viskosität ML (1+4)/100°C = 45)

3,0 Teile Glycidylmethacrylat

5,0 Teile Hexandioldiacrylat

1,0 Teile Benzildimethylketal

1,0 Teile 2,6-Di-tert.-butyl-p-kresol (Kerobit® TBK)

9,0 Teile Butylethanolamin

1,0 Teile N-nitroso-N-cyclohexylhydroxylamin (Kaliumsalz)

0,004 Teile Safranin T (C.I. 50 240)

Die beiden Bindemittel wurden in den Zweischneckenextruder eindosiert.

Nach der Aufschmelzzone wurden Glycidylmethacrylat, die Mischung aus Hexandioldiacrylat, Benzildimethylketal, 2,6-Di-tert.-butyl-p-kresol und danach Butylethanolamin zudosiert. Schließlich wurde eine 30 %ige wäßrige Lösung aus Safranin T und dem N-nitroso-N-cyclohexylhydroxylamin K-Salz zudosiert. Der Gesamtdurchsatz betrug 20 kg/h. Die Temperatur lag in der Aufschmelzzone bei ca. 150°C, in der

4

Mischzone bei ca. 130°C und in der Austragszone bei ca. 115°C.

Die Lösungsmittel wurden in einem Entgasungsdom wieder aus der Schmelze abgezogen.

Die aus der Breitschlitzdüse ausgetragene Schmelze wurde in den Spalt (Dicke 1,3 mm) eines Zweiwalzenkalanders geleitet, wo die Schmelze geglättet und mit den über die Kalanderwalzen einlaufenden Deck- und Trägerfolien haftfest verbunden wurde.

Als Deckfolie wurde eine 125 $\mu$m dicke Polyethylenterephthalatfolie (Mylar® der Fa. DuPont de Nemours) verwendet, die zuvor auf einer Seite mit einer 5 $\mu$m dicken Entklebungsschicht aus einem Polyvinylalkohol/Ethylenoxid-Pfropfcopolymer (Mowiol® 04/86 der Firma Hoechst AG) beschichtet worden war.

Als Trägerfolie wurde eine 300 $\mu$m dicke, vorbeschichtete Polyethylenterephthalatfolie (z.B. Hostaphan® RN der Fa. Hoechst AG) eingesetzt. Diese Folie wurde mit einem Haftlack in einer Dicke von 5 $\mu$m beschichtet. Der hierfür verwendete Haftlack bestand aus einem Gemisch aus gleichen Teilen Polycarbonat (z.B. Makrolon®2800 der Fa. Albis Plastic Chemie GmbH), Phenoxyharz (z.B. PKHH der Fa. Brenntag, Mülheim/Ruhr) und Vernetzer auf Isocyanatbasis (z.B. Desmodur®L der Fa. Bayer AG).

Die Folien wurden so in den Kalander eingefahren, daß die lichtempfindliche Schmelze mit Entklebungsschicht und Haftschicht verbunden wurde. Danach wurde der Verbund auf einem Vakuumsaugband abgekühlt und formatgerecht zugeschnitten.

A. Photochemische Strukturierung

Von der Druckplatte wurde die Deckfolie abgezogen und ein Negativ aufgelegt. Die Platte wurde mit einer Vakuumfolie überzogen und bildmäßig 10 Minuten in einem 70 Watt-Belichter mit aktinischem Licht (Wellenlänge 350 bis 400$\mu$m) unter Vakuum belichtet.

Das Negativ wurde entfernt, und die Platte in einem Trommelbürstenwascher in 1 %iger Sodalösung bei 50°C in 12 Minuten bis auf die Trägerfolie ausgewaschen. Die Druckform wurde dann 2 Stunden bei 60°C getrocknet und anschließend nochmals 10 Minuten nachbelichtet.

Die so erhaltene Druckform wird als Druckform (1a) bezeichnet.

B.1 Mechanische Strukturierung

Die Druckplatte wurde von beiden Seiten 10 Minuten lang vollflächig ohne Anlegen von Vakuum bestrahlt. Danach wurde die Deckfolie abgezogen und die Druckplatte 10 Minuten in 1%ige Sodalösung getaucht. Hierbei löste sich die dünne Entklebungsschicht auf.

Die vernetzte und klebfreie Druckplatte wurde dann auf den Schneidtisch einer Rechner gesteuerten Schneidapparatur (Marbaplot der Fa. Marbach) gelegt, mit Vakuum angesaugt und geschnitten. Die im Rechner erzeugte Vorlage enthielt positive und negative Elemente (Vollflächen, Linien, Kreise, Punkte) in variabler Größe (von 0,5 mm bis zu einigen cm). Die Schnittiefe des Messers wurde auf die Dicke der Aufzeichnungsschicht + zusätzlich 20 $\mu$m eingestellt. Die Schneidgeschwindigkeit betrugt 3 cm/s.

Die so erhaltene Druckform wird als Druckform (1b) bezeichnet.

B.2 Mechanische Strukturierung

Die Druckplatte wurde von der Vorderseite 10 Minuten lang vollflächig ohne Anlegen von Vakuum bestrahlt. Danach wurde die Deckfolie abgezogen. Die Druckplatte wurde anschließend mit einer Rechner gesteuerten Schneidapparatur geschnitten. Die Nichtbildstellen wurden abgezogen.

Die dünne Entklebungsschicht wurde anschließend durch Reiben mit einem in einer 1%igen Sodalösung getränkten Plüsch entfernt.

Die so erhaltene Druckform wird als Druckform (1c) bezeichnet.


Vergleichsbeispiel 1:

Die folgende Mischung wurde entsprechend Beispiel 1 auf einem Zweischneckenextruder verarbeitet.

83 Teile Styrol-Isopren-Styrol-Blockcopolymer (Cariflex®1107 der Fa. Shell)

5 Teile Hexandioldiacrylat

5 Teile Hexandioldimethacrylat

5 Teile Parrafinöl (Weißöl S 5000)

1 Teile Benzildimethylketal

1 Teile 2,6-Di-tert.-butyl-p-kresol

0,006 Teile Sudantiefschwarz BB (C.I. 26150)

Wie in Beispiel 1 wurde die Schmelze im Kalander mit Deck- und Trägerfolie haftfest verbunden.

Als Deckfolie wurde eine gewöhnliche 125 $\mu$m dicke Polyethylenterephthalatfolie (Mylar) eingeführt, die zuvor auf einer Seite mit einer 5 $\mu$m dicken Entklebungsschicht eines Polyamids (Makromelt® 6900 der Fa. Henkel) beschichtet worden war.

A. photochemische Strukturierung

Aus der Rohplatte wurde eine Druckform hergestellt. Hierzu mußte zunächst aus der Bildvorlage ein Negativ hergestellt werden. Danach wurde die Deckfolie abgezogen und das Negativ auf die Druckplatte aufgelegt. Der Verbund wurde mit einer transparenten Vakuumfolie überzogen und unter Vakuum 10 Minuten bildmäßig belichtet.

Nach Entfernen des Negativs wurde die Druckplatte in einem Trommelbürstenwascher in einer Mischung aus 80 Vol.-Teilen Exxsol® D 60 und 20 Vol.-Teilen n-Pentanol ausgewaschen. Die Temperatur der Auswaschlösung betrug 30°C. Nach einer Auswaschzeit von 15 Minuten war die Druckplatte bis auf den Haftlack der Trägerfolie ausgewaschen. Die Druckform wurde dann 2 Stunden bei 60°C getrocknet und nach einer Ruhezeit von 12 Stunden durch Tauchen in eine wäßrige Bromlösung (5 Minuten) entklebt.

Die so erhaltene Druckform wird als Druckform (2a) bezeichnet.

B. mechanische Struktutierung

Die Druckplatte wurde von beiden Seiten 10 Minuten vollflächig bestrahlt. Danach wurde die Deckfolie abgezogen und die Druckplatte 2 Minuten in einem Trommelbürstenwascher mit n-Pentanol behandelt. Hierbei löst sich die dünne Entklebungsschicht auf. Danach wurde die Druckplatte 10 Minuten bei 60°C getrocknet und nach Abkühlung auf Raumtemperatur durch Tauchen in eine wäßrige Bromlösung entklebt.

Die Druckplatte wurde dann entsprechend Beispiel 1 mechanisch strukturiert.

Die so erhaltene Druckform wird als Druckform (2b) bezeichnet.

Vergleichsbeispiel 2:

Ein für die Offsetlackierung handelsübliches Gummituch wurde mechanisch strukturiert, wobei das Gummituch auf den Schneidtisch einer rechnergesteuerten Schneidapparatur (z.B. Marbaplot) gelegt, mit Vakuum angesaugt und geschnitten wurde. Die im Rechner erzeugte Vorlage entsprach der in Beispiel 1 verwendeten.

Die so erhaltene Druckform wird als Druckform (3) bezeichnet.

Beispiel 2

Eine lichtempfindliche Mischung wurde auf einem Zweischneckenextruder verarbeitet. Die Formulierung enthielt folgende Bestandteile:

40 Teile Ethylen-Acrylsäure-Acrylat-Copolymer (wie in Beispiel 1)

40 Teile Ethylen-Propylen-Dienkautschuk (Buna AP 251) (wie in Beispiel 1)

3,0 Teile Glycidylmethacrylat

5,0 Teile Hexandioldiacrylat

1,0 Teile Benzildimethylketal

1,0 Teile 2,6-Di-tert.-butyl-p-kresol (Kerobit TBK)

5,0 Teile Isophorondiamin

Die aus der Breitschliztdüse austretende Schmelze wurde in den Spalt (Dicke 1,3 mm) eines Zweiwalzenkalanders geleitet, wo die Schmelze geglättet und mit Deck- und Trägerfolie haftfest verbunden wurde.

Als Trägerfolie wurde eine 300 $\mu$m dicke, vorbeschichtete Polyethylenterephthalatfolie (Hostaphan RN der Fa. Hoechst AG) eingesetzt, die zuvor mit einem Haftlack in einer Dicke von 5 $\mu$m beschichtet worden war.

Als Deckfolie wurde eine 75 $\mu$m dicke, nicht beschichtete Polyethylenterephthalatfolie (Hostaphan RN der Fa. Hoechst AG) eingesetzt.

Der Verbund wurde mittels eines Vakuumsaugbandes abgezogen. Die Rohplatten durchliefen eine Belichtungsstation. Die Verweilzeit der Platten unter den Lampen und die Leuchtstärke der Lampen entsprachen einer Belichtungszeit von 5 Minuten auf einem 70 W Belichter.

Mechanische Strukturierung

Die Druckplatte wurde auf den Schneidtisch einer Rechner-gesteuerten Schneidapparatur gelegt, die Deckfolie entfernt mit Vakuum angesaugt und entsprechend Beispiel 1 (Herstellung der Druckform (1b)) geschnitten.

Die so erhaltene Druckform wird als Druckform (4) bezeichnet.

Die mit den einzelnen Druckplatten/Druckformen erhaltenen Ergebnisse sind in der folgenden Tabelle zusammengefaßt.

Tabelle

| Prüfgröße | Druckform | | | | | | |
|---|---|---|---|---|---|---|---|
| | (1a) | (1b) | (1c) | (2a) | (2b) | (3) | (4) |
| **Eigenschaften der Druckform** | | | | | | | |
| Shore A (6 mm Probe) | 39 | 40 | 40 | 46 | 48 | /1/ | 50 |
| Haftung Druckschicht/Träger in N/2 cm /2/ | 7 | 9 | 9 | 8 | 10 | 8 | 8 |
| Zugversuch /3/ Reißdehnung in % | 210 | 220 | 220 | 350 | 400 | /1/ | 160 |
| Reißkraft in N/mm$^2$ | 1,8 | 2,0 | 2,0 | 1,9 | 2,3 | /1/ | 3,1 |
| Weiterreißfestigkeit nach DIN 53 507 Median in N/mm | 1,7 | 1,8 | 1,8 | 1,9 | 2,2 | /1/ | 2,6 |
| Spannweite in N/mm /4/ | 0 | 0 | 0 | 0,5 | 0,6 | /1/ | 0 |
| **Schneidergebnis** | | | | | | | |
| Kantenschärfe | | gut | gut | | gezackt | gut | gut |
| Abziehbarkeit großer Flächen | | gut | gut | | reißt/5/ | gut | gut |
| Abziehbarkeit negativer Elemente | | gut | gut | | mäßig | schlecht | gut |
| Auflösung | | 1 mm | 1 mm | | 5 mm | 10 mm | 1 mm |

EP 0 565 818 A2

| Prüfgröße | Druckform | | | | | | |
|---|---|---|---|---|---|---|---|
| | (1a) | (1b) | (1c) | (2a) | (2b) | (3) | (4) |
| **Druckversuch /6/** | | | | | | | |
| Farbaufbau nach Auflage | > 50 000 | > 50 000 | > 50 000 | 500 | 1000 | 3000 | >50 000 |
| Passergenauigkeit | gut | gut | gut | gut | gut | schlecht | gut |
| Quellung im Lack /7/ | 9,5 | 6,5 | 5,2 | 0,6 | 0,6 | 0,3 | 3,0 |
| Gleichmäßigkeit Lackauftrag | gut | gut | gut | gut | gut | Quetsch-rand | gut |

Bewertung bzw. Erläuterung zur Tabelle:

/1/ nicht bestimmbar, da nur mit Gewebelage abziehbar

/2/ Abzugwinkel 90°, Abzugsgeschwindigkeit 100 mm/min

/3/ Zugversuch, Einspannlänge 10 cm, Probenbreite 1,5 cm, Probenstärke 1 mm, Abzugsgeschwindigkeit 10 cm/min

/4/ Spannweite gibt die Gleichmäßigkeit des Reißens wieder
Spannweite 0 = keine Kraftspitzen, Spannweite 0,6 = Kraftspitzen, die bis zu 0,6 N/mm auseinanderliegen

/5/ abzuziehender Streifen reißt an nicht sauber ausgeschnittenen Kanten und Ecken ein

/6/ Offset Bogendruckmaschine MAN-Roland 600, mit Lackierwerk, Wasserlack Senolith® Polylack, Viskosität 30 sec

/7/ Gewichtszunahme in % nach 24 Stunden Lagerung im Wasserlack, auf Reliefschicht bezogen, einseitige Quellung mit Trägerfolie

Die in der Tabelle angegebenen mechanischen Daten (Härte, Reißdehnung, Weiterreißfestigkeit) der erfindungsgemäß hergestellten Druckformen (1a) und (1b) stimmen gut mit den Daten der Druckformen aus den Vergleichsversuchen Druckform (2a) und (2b) überein. Unterschiede gibt es nur in der Gleichmäßigkeit des Reißens nach DIN 53 507. Im Kraft-Weg Diagramm der erfindungsgemäßen Druckformen (1a) und (1b) sind keinerlei Unstetigkeiten, d.h. keine Kraftspitzen, feststellbar. Dagegen zeigen die Druckformen der

8

Vergleichsversuche (2a) und 2b) zahlreiche Kraftspitzen. Die Proben zerreißen ungleichmäßig.

Dieser Unterschied ist für die Qualität der mechanischen Strukturierung entscheidend. Mit der erfindungsgemäßen Druckplatte (1b) liegt die Auflösung bei 1 mm. Die Flanken der ausgeschnittenen Elemente sind gleichmäßig glatt. Die Flanken der Vergleichsdruckform (2b) sind dagegen gezackt. Die Auflösung der mechanischen Strukturierung ist hier deutlich geringer. Hinzukommt, daß die Schnitte oftmals nicht bis an die Ecken der Bildelemente verlaufen. Beim Abziehen werden deshalb die Ecken abgehoben oder bei kleinen Elementen ganz entfernt. Die Auflösung des mechanischen strukturierten Gummituchs ist nochmals geringer, da beim Abziehen nicht nur die oberste Schicht, sondern auch eine darunterliegende Gewebelage mitabgezogen werden muß. Der Anfang der abzuziehenden Schicht ist schwer zu finden. Zudem fasert die Gewebelage beim Abziehen auf.

Bei der photochemischen Strukturierung ist die Auflösung naturgemäß höher (0,02 mm). Hier unterscheidet sich die erfindungsgemäß hergestellte Druckform (1a) nicht wesentlich von der Vergleichsdruckform (1b). Die Daten wurden daher in der Tabelle weggelassen. Ein entscheidender Vorteil ist aber, daß die photochemische Strukturierung der Druckform (1a) ohne organische Lösungsmittel möglich ist.

Im Druckversuch schneiden nur die erfindungsgemäß hergestellten Druckformen (1a) und (1b) gut ab. Die konventionellen Druckplatten und das Gummiklischee zeigen schon nach wenigen Bogen Farbaufbau, wobei der Ausdruck des Gummituches zusätzlich noch Quetschränder aufweist. Zudem verschlechtert sich der passergenaue Lackauftrag des Gummiklischees während der Auflage.

## Patentansprüche

1. Verfahren zur Herstellung von flexiblen Druckformen aus Druckplatten, im wesentlichen bestehend aus einem formstabilen Träger (1) und einer Aufzeichnungsschicht (2), dadurch gekennzeichnet, daß die Herstellung der Druckform wahlweise entweder durch photochemische oder durch mechanische Strukturierung erfolgt, wobei im Falle der photochemischen Strukturierung die lichtempfindliche Aufzeichnungsschicht (2) bildmäßig belichtet und die nicht belichteten Teile der Aufzeichnungsschicht (2) mit einem Entwickler ausgewaschen werden, im Falle der mechanischen Strukturierung die ursprünglich lichtempfindliche, vollflächig belichtete Aufzeichnungsschicht (2) bildmäßig geschnitten und die nichtdruckenden Teile der Aufzeichnungsschicht (2) vom Träger (1) abgezogen werden.

2. Verfahren nach Anspruch 1, dadurch gekennzeichnet, daß sich auf der Aufzeichnungsschicht (2) eine Schutzfolie (3) befindet.

3. Verfahren nach Anspruch 1 oder 2, dadurch gekennzeichnet, daß sich zwischen der lichtempfindlichen Aufzeichnungsschicht (2) und der Schutzfolie (3) eine dünne Entklebungsschicht (2a) befindet, die im Falle der photochemischen Strukturierung nach der bildmäßigen Belichtung entfernt wird, im Falle der mechanischen Strukturierung vor oder nach dem bildmäßigen Schneiden abgezogen oder abgewaschen wird.

4. Verfahren nach einem der vorhergehenden Ansprüche, dadurch gekennzeichnet, daß sich zwischen der Aufzeichnungsschicht (2) und dem formstabilen Träger (1) eine Haftschicht (1a) befindet.

5. Verfahren nach einem der vorhergehenden Ansprüche, dadurch gekennzeichnet, daß als formstabiler Träger (1) eine maßhaltige Kunststoffolie eingesetzt wird.

6. Verfahren nach einem der vorhergehenden Ansprüche, dadurch gekennzeichnet, daß die Haftung der Aufzeichnungsschicht (2) zum formstabilen Träger (1) oder zu einer auf dem formstabilen Träger (1) befindlichen Haftschicht (1a) über 1 N/cm und unter 10 N/cm liegt.

7. Verfahren nach einem der vorhergehenden Ansprüche, dadurch gekennzeichnet, daß im Falle der mechanischen Strukturierung die Reißkraft der Aufzeichnungsschicht (2) über 0,2 $N/mm^2$ und unter 20 $N/mm^2$ liegt.

8. Verfahren nach einem der vorhergehenden Ansprüche, dadurch gekennzeichnet, daß die Härte der belichteten Aufzeichnungsschicht (2) über 20 und unter 80 Shore A liegt.

9. Verfahren nach einem der vorhergehenden Ansprüche, dadurch gekennzeichnet, daß im Falle der photochemischen Strukturierung als Entwickler Wasser oder wäßrige Lösungen verwendet werden.

10. Verfahren nach einem der vorhergehenden Ansprüche, dadurch gekennzeichnet, daß die lichtempfindliche Aufzeichnungsschicht (2) ein Gemisch aus einem hydrophoben und einem hydrophilen Bindemittel in solchen Anteilen enthält, daß die belichtete und mit Entwickler ausgewaschene Aufzeichnungsschicht (2) nach 24 Stunden Lagerung in Wasser bei Raumtemperatur eine Gewichtszunahme von > 1 Gew.-% und < 30 Gew.-% aufweist.

11. Verfahren zur Herstellung von Flexodruckerzeugnissen, dadurch gekennzeichnet, daß als Druckformen solche eingesetzt werden, die nach einem Verfahren gemäß einem der vorhergehenden Ansprüche hergestellt wurden.

12. Verfahren zur Lackierung von Offsetdruckerzeugnissen, dadurch gekennzeichnet, daß die Lackübertragung durch die nach einem Verfahren gemäß einem der Ansprüche 1 bis 10 hergestellten Druckformen erfolgt.